# EUROPEAN PATENT APPLICATION

(11) **EP 4 525 027 A1**
(43) Date of publication of application: **19.03.2025**
(21) Application number: 24199179.3
(22) Date of filing: 09.09.2024
(51) Int. Cl.: H01L 21/48, H01L 21/56, H01L 23/31, H01L 23/495, H01L 23/498

(54) **SEMICONDUCTOR DEVICE WITH ENHANCED SOLDERABILITY AND METHOD THEREFOR**

(30) Priority: 18.09.2023 US 202318468958
(71) Applicant: NXP B.V., 5656 AG Eindhoven (NL)
(72) Inventor: Lin, Yen-Chih, 5656AG Eindhoven (NL); Chang, Yao Jung, 5656AG Eindhoven (NL); Huang, Kuan Lin, 5656AG Eindhoven (NL); Tsi, Yi-Hsuan, 5656AG Eindhoven (NL); Meng-huang, Sie, 5656AG Eindhoven (NL)
(74) Representative: Hardingham, Christopher Mark

(57) **Abstract**

A method of forming a semiconductor device is provided. The method includes mounting a semiconductor die on a die pad of a leadframe. The die pad includes a central opening configured to expose a central portion of the semiconductor die. A first end of a bond wire is attached to a bond pad of the semiconductor die and a second end of the bond wire is attached to a lead of the leadframe. An encapsulant encapsulates the semiconductor die and the leadframe. A portion of the lead and a portion of the die pad are exposed and protruded through the encapsulant.

## Description

### Background

### Field

This disclosure relates generally to semiconductor device packaging, and more specifically, to semiconductor devices with enhanced solderability and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower reliability, lower performance, and higher product or system costs. Accordingly, significant challenges exist in accommodating these features and applications while minimizing the impact on semiconductor devices' reliability, performance, and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified bottom-side-up plan view, an example semiconductor device having enhanced solderability at a stage of manufacture in accordance with an embodiment.
FIG. 2 through FIG. 8 illustrate, in simplified cross-sectional views, the example semiconductor device at stages of manufacture in accordance with an embodiment.

### Detailed Description

Generally, there is provided, a semiconductor device having enhanced solderability. The semiconductor device includes a semiconductor die mounted on a die pad of a leadframe. A plurality of leads of the leadframe substantially surround the die pad. The die pad is formed with a central opening through the die pad. An outer perimeter portion of the back of the semiconductor die is affixed to an outer perimeter portion of the die pad such that a central portion of the semiconductor die is exposed through the opening. A redistribution layer substrate is formed on the semiconductor die portion exposed through the opening. The redistribution layer substrate is configured to interconnect through-silicon vias of the semiconductor die with a component affixed within the opening of the die pad. The component may be a second semiconductor die, a sensor, a passive component, an integrated passive, for example. The semiconductor die and portions of the leadframe and the component are encapsulated with an encapsulant. Each lead of the plurality of leads includes a lead portion exposed and protruded through the bottom side of the encapsulant. Likewise, the bottom side of the die pad and a bottom side of the component are exposed and protruded through the bottom side of the encapsulant. By forming the semiconductor device in this manner, the component may be included in the semiconductor device with little to no impact to the height or thickness of the semiconductor package. Further, by encapsulating the semiconductor device such that protruded leads and die pad are formed, the additional surface area of the protruded leads and die pad provide enhanced solderability when mounting the semiconductor device onto a printed circuit board, for example.

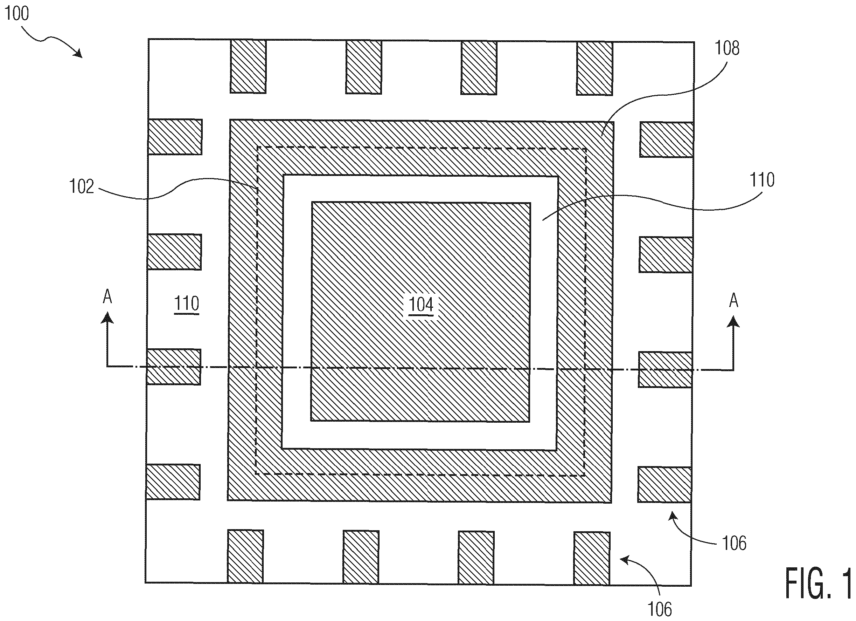

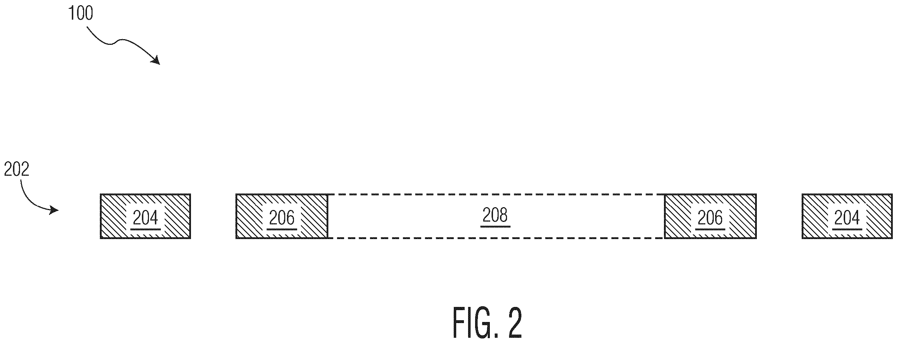

FIG. 1 illustrates, in a simplified bottom-side-up plan view, an example semiconductor device 100 having enhanced solderability at a stage of manufacture in accordance with an embodiment. At this stage, the semiconductor device 100 includes an embedded semiconductor die 102 (shown as dashed outline for reference), a component 104, and a package leadframe including a die pad 108 and a plurality of conductive leads 106 surrounding the die pad encapsulated with an encapsulant 110. In this embodiment, the die pad 108 is formed with a central opening. The component 104 is located substantially within the central opening and interconnected with the semiconductor die 102 in a stacked arrangement. Portions of the component 104, the plurality of leads 106, and the die pad 108 are exposed and protruded through the bottom side of the encapsulant 110. In this embodiment, the semiconductor device 100 may be characterized as having a quad flat no-lead (QFN) package type leadframe. The number and arrangement of the plurality of leads 106 and size and shape of the die pad 108 with the central opening in this embodiment are chosen for illustration purposes. The term "conductive," as used herein, generally refers to electrical conductivity unless otherwise described. Simplified cross-sectional views of the example semiconductor device 100 taken along line A-A at stages of manufacture are depicted in FIG. 2 through FIG. 8.

FIG. 2 illustrates, in a simplified cross-sectional view, the example semiconductor device 100 taken along line A-A at a stage of manufacture in accordance with an embodiment. At this stage, the semiconductor device 100 includes a package leadframe 202 including a die pad 206 and a plurality of conductive leads 204. In this embodiment, the die pad 206 includes an opening 208 illustrated with dashed lines. The opening 208 is centrally located within the die pad 206 and configured to expose a portion of a semiconductor when mounted on the die pad 206 at a subsequent stage of manufacture. For example, with a first side of the semiconductor die mounted on a top side of the die pad 206, a central portion of the first side of the semiconductor die is exposed at the bottom side of the die pad.

The leadframe 202 may be formed from any suitable electrically conductive metal material, such as copper, silver, nickel, aluminum, or iron, or alloys thereof, for example. The conductive metal may be bare, partially plated, or plated with another metal or alloy thereof. In this embodiment, the die pad 206 and the plurality of leads 204 of the leadframe 202 are formed from a common metal sheet. In some embodiments, the leadframe 202 may include characteristics suitable for thermal conduction as well as electrical conduction. The number and arrangement of leads 506 of the leadframe 502 are chosen for illustration purposes. In this embodiment, the leadframe 202 may be characterized as a QFN package type leadframe.

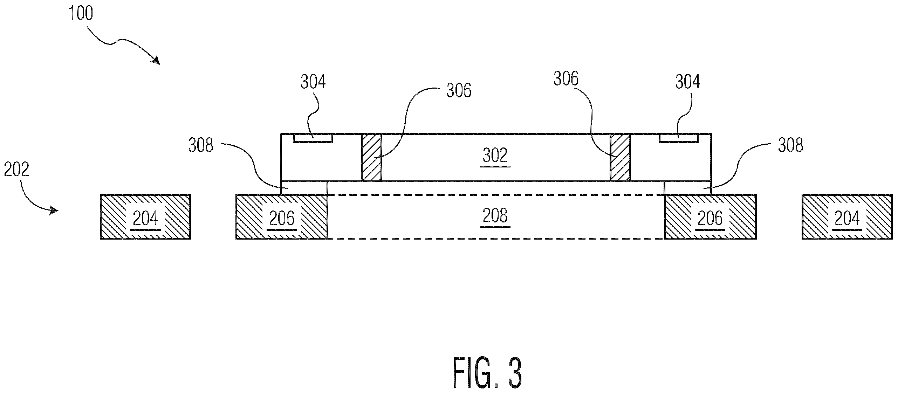

FIG. 3 illustrates, in a simplified cross-sectional view, the example semiconductor device 100 taken along line A-A at a subsequent stage of manufacture in accordance with an embodiment. At this stage, the semiconductor device 100 includes a semiconductor die 302 mounted on the die pad 206 of the leadframe 202. In this embodiment, a backside of the semiconductor die 302 is affixed to the top surface of the die pad 206 by way of a die attach material 308. The die attach material 308 may be a paste, film, or solder material, for example. In this embodiment, an outer perimeter portion of the semiconductor die 102 is attached to the die pad 206 allowing a central portion of the semiconductor die 302 to be exposed through the opening 208 of the die pad 206.

The semiconductor die 302 has an active side (e.g., major side having circuitry, bond pads) and a backside (e.g., major side opposite of the active side). As depicted in the cross-sectional view of FIG. 3, the semiconductor die 302 is mounted on the die pad 206 in an active-side-up orientation, for example. The semiconductor die 302 includes bond pads 304 located at the active side of the semiconductor die and configured for connection to the leads 204. In this embodiment, the semiconductor die 302 further includes through silicon vias (TSV) 306 configured to provide conductive connection between the backside and the active side of the semiconductor die. The TSVs are located such that the one or more of the TSVs are accessible by way of the opening 208 through the die pad 206. The semiconductor die 302 may be formed from any suitable semiconductor material, such as silicon, germanium, gallium arsenide, gallium nitride, and the like. The semiconductor die 302 may further include any digital circuits, analog circuits, RF circuits, power circuits, memory, processor, sensor, the like, and combinations thereof at the active side.

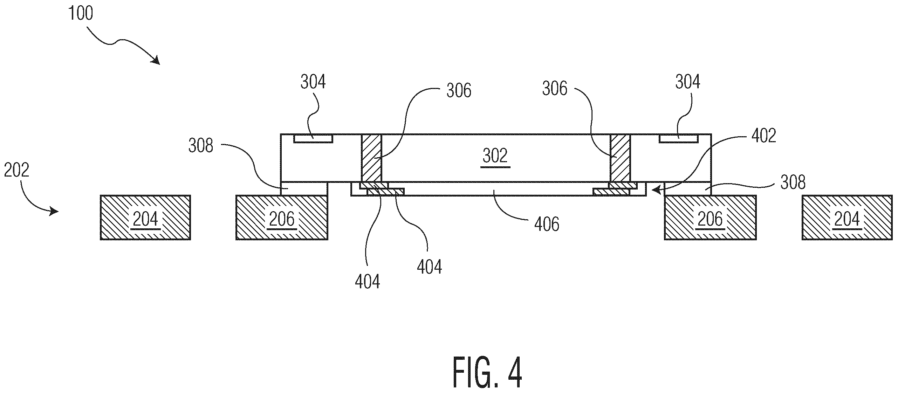

FIG. 4 illustrates, in a simplified cross-sectional view, the example semiconductor device 100 taken along line A-A at a subsequent stage of manufacture in accordance with an embodiment. At this stage, the semiconductor device 100 includes an RDL substrate 402 is applied to the backside of the semiconductor die 102. The RDL substrate 402 includes conductive features 404 such as traces, vias, and the like surrounded by non-conductive material (e.g., dielectric) 406. In this embodiment, the conductive traces are formed from patterned metal (e.g., copper) layers separated by dielectric layers of the RDL substrate 402. The conductive features 404 are formed in the RDL substrate 402 to interconnect the TSVs 306 of the semiconductor die 102 with a subsequently attached component, for example. The RDL substrate 402 may be formed as a build-up substrate directly on the backside of the semiconductor die 102 or may be provided as a pre-formed substrate otherwise applied on the backside of the semiconductor die 102.

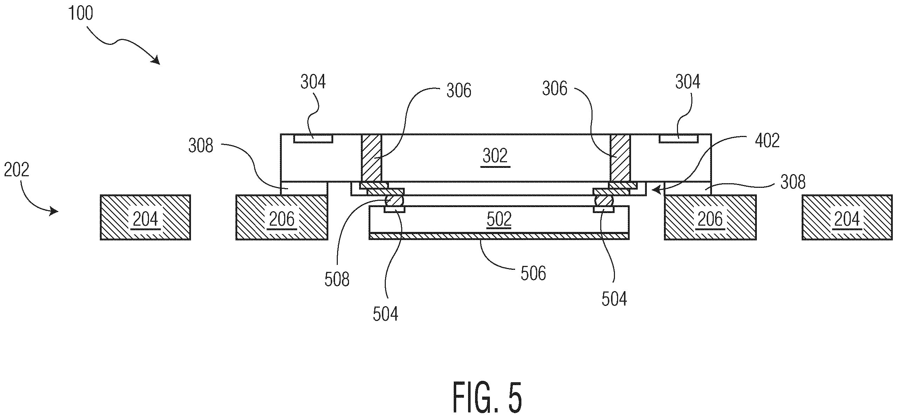

FIG. 5 illustrates, in a simplified cross-sectional view, the example semiconductor device 100 taken along line A-A at a subsequent stage of manufacture in accordance with an embodiment. At this stage, the semiconductor device 100 includes a component 502 interconnected with the semiconductor die 302 by way of the RDL substrate 402. The component 502 may be characterized as a second semiconductor die, a passive component (e.g., resistor, capacitor, inductor), integrated passive device (e.g., stripline, passive filter circuit, coil, balun), the like, and combinations thereof.

The component 502 may be interconnected with circuitry (not shown) and/or bond pads 304 at the active side of the semiconductor die 102, for example. In this embodiment, conductive pads (e.g., terminals, bond pads, contacts) 504 of the component 502 are connected with conductive features (e.g., exposed traces) of the RDL substrate 402 by way of conductive connectors 508. The conductive connectors 508 may be in the form of suitable conductive structures and materials (e.g., solder balls, gold studs, copper pillars, solder paste), to connect conductive pads 504 of the component 502 with conductive features of the RDL substrate 402. In this embodiment, the component 502 is located substantially within the opening 208 (of FIG. 3). By interconnecting the component 502 with the semiconductor die 102 in this stacked manner, package height (e.g., thickness) may be reduced significantly. The component 502 may further include a backside metallization coating or film 506. In this embodiment, the bottom surfaces of the leads 204, die pad 206, and component 502 are substantially coplanar with one another.

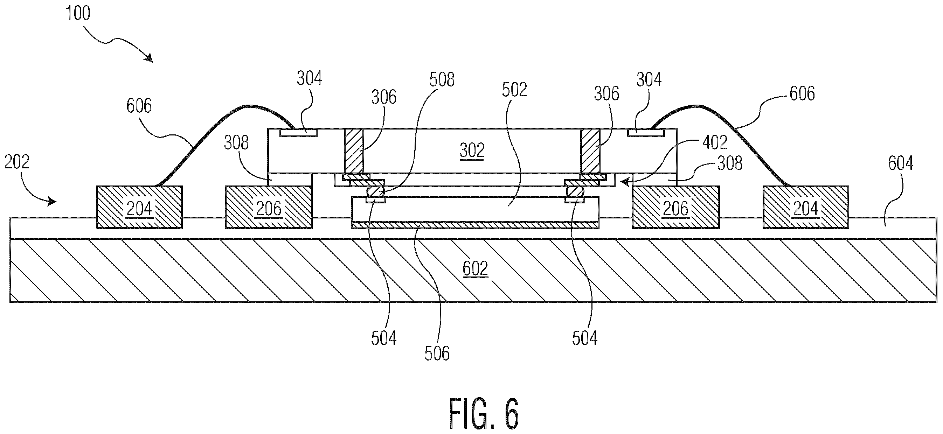

FIG. 6 illustrates, in a simplified cross-sectional view, the example semiconductor device 100 taken along line A-A at a subsequent stage of manufacture in accordance with an embodiment. At this stage, the semiconductor device 100 includes the leadframe 202 with mounted semiconductor die 302 and interconnected component 502 (as depicted in FIG. 5) placed on a carrier substrate 602 and wire bonded. The carrier substrate 602 includes a releasable adhesive 604 applied on a top surface. The releasable adhesive 604 is chosen such that the bottom portion of the leads 204, die pad 206, and component 502 may be embedded in the releasable adhesive 604. The carrier substrate 602 is configured and arranged to provide a temporary structure for wire bonding and encapsulation at a subsequent stage of manufacture, for example.

In this embodiment, bond pads 304 of the semiconductor die 302 interconnected to leads 204 by way of bond wires 606. In this embodiment, a first end of the bond wires 606 is attached to the bond pads 304 by way of a first bond (e.g., ball bond) and a second end of the bond wires 606 is attached to a bonding region at the top surface of the leads 204 by way of a second bond (e.g., stitch bond).

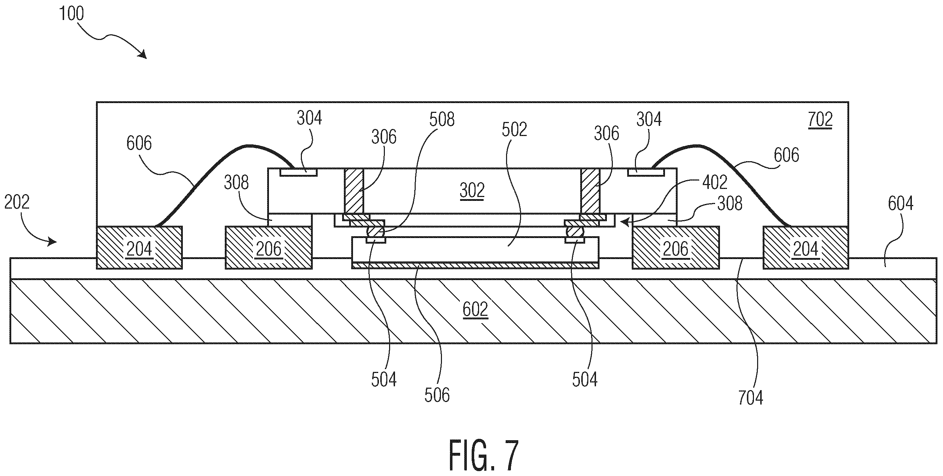

FIG. 7 illustrates, in a simplified cross-sectional view, the example semiconductor device 100 taken along line A-A at a subsequent stage of manufacture in accordance with an embodiment. At this stage, the semiconductor device 100 includes the leadframe 202 with the wire bonded semiconductor die 302 and interconnected component 502 (as depicted in FIG. 6) encapsulated with an encapsulant 702 while temporarily affixed on the carrier substrate 602. In this embodiment, the semiconductor die 302, the leadframe 202, and interconnected component 502 are over-molded with the encapsulant (e.g., epoxy molding compound) 702 by way of an injection molding or transfer molding process, for example. The molding process is configured to encapsulate the semiconductor die 302 and portions of the leadframe 202 and interconnected component 502 which are not embedded in the releasable adhesive 604. Accordingly, a bottom surface 704 of the encapsulant 702 is formed at the top surface of the releasable adhesive 604 of the carrier substrate 602.

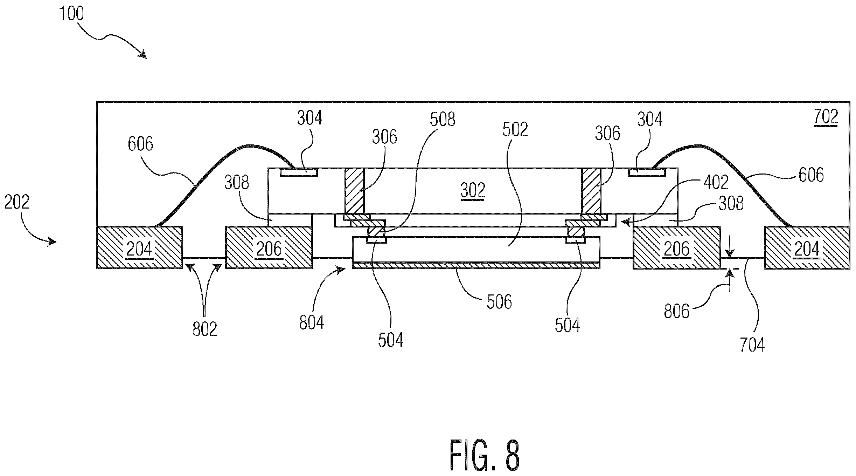

FIG. 8 illustrates, in a simplified cross-sectional view, the example semiconductor device 100 taken along line A-A at a subsequent stage of manufacture in accordance with an embodiment. At this stage, the encapsulated semiconductor device 100 is separated from the carrier substrate 602. In this embodiment, a portion of the bottom side of the component 502 and portions of the bottom side of the leads 204 and the die pad 206 of the leadframe 502 are revealed at a bottom side of the encapsulated semiconductor device 100 when the carrier substrate 602 is removed. After the carrier substrate 602 is removed, the exposed portions of the component 502, leads 204, and die pad 206 essentially extend below the bottom surface 704 of the encapsulant 702. In this embodiment, the exposed bottom surfaces of the component 502, leads 204, and die pad 206 are substantially coplanar.

Because the bottom portion of the leads 204, die pad 206, and component 502 are partially embedded in the releasable adhesive 604 (of FIG. 7) during the encapsulation process, removing the carrier substrate after the encapsulation process exposes bottom portions 802 of the leads 204 and die pad 206 of the leadframe 202 and bottom portion 804 component 502 which substantially protrude beyond the bottom surface 704 of the encapsulant 702 by a predetermined protruded distance 806. In this embodiment, the predetermined protruded distance 806 may be in a range of approximately 10% to 50% of the thickness of the leads 204 or die pad 206. By forming the encapsulant 702 in this manner, the protruded portions 802 of the leads 204 and die pad 206 and protruded portion 804 of the component 502 have additional surface areas (e.g., sidewall portions) for superior solder wetting when conductively affixed to a printed circuit board (PCB), for example.

Generally, there is provided, a method including mounting a semiconductor die on a die pad of a leadframe, the die pad having a central opening configured to expose a central portion of the semiconductor die; attaching a first end of a bond wire to a bond pad of the semiconductor die and a second end of the bond wire to a lead of the leadframe; and encapsulating with an encapsulant the semiconductor die and the leadframe, a portion of the lead and a portion of the die pad exposed and protruded through the encapsulant. The method may further include before encapsulating with the encapsulant, interconnecting a component located within the central opening with a through-silicon via (TSV) of the semiconductor die. The component located within the central opening may be interconnected with the TSV by way of a redistribution layer formed on the semiconductor die. A bottom portion of the component may protrude through the encapsulant after encapsulating with the encapsulant. The method may further include forming a metal layer on a bottom side of the component. The component may be characterized as at least one of a second semiconductor die and a passive integrated device (PID). A bottom surface of the component may be substantially coplanar with a bottom surface of the die pad. The central opening of die pad may be configured to expose the central portion of a backside of the semiconductor die. The leadframe may be characterized as a quad flat no-lead (QFN) package type leadframe.

In another embodiment, there is provided, a semiconductor device including a leadframe including a die pad and a plurality of leads, the die pad having a central opening through the die pad; a semiconductor die mounted on the die pad of the leadframe, a portion of the semiconductor die exposed through the central opening; and an encapsulant encapsulating with the semiconductor die and the leadframe, a portion of the die pad and plurality of leads exposed and protruded through the encapsulant. The semiconductor device may further include a bond wire having a first end connected to a bond pad of the semiconductor die and a second end of the bond wire connected to a lead of the plurality of leads. The semiconductor device may further include a component located substantially within the central opening, the component interconnected with a through-silicon via (TSV) of the semiconductor die. The component located within the central opening may be interconnected with the TSV by way of a redistribution layer formed on the semiconductor die. A bottom portion of the component may be exposed and protruded through the encapsulant, and wherein a bottom surface of the component may be substantially coplanar with a bottom surface of the die pad. The component may be characterized as at least one of a second semiconductor die and a passive integrated device (PID).

In yet another embodiment, there is provided, a method including mounting a semiconductor die on a die pad of a leadframe, the die pad having a central opening exposing a backside portion of the semiconductor die; attaching a first end of a bond wire to a bond pad of the semiconductor die and a second end of the bond wire to a lead of the leadframe; interconnecting a component with a through-silicon via (TSV) of the semiconductor die, the component located substantially within the central opening of the die pad; and encapsulating with an encapsulant the semiconductor die, the leadframe, and the component. A portion of the lead, a portion of the die pad, and a portion of the component may be exposed and protruded through the encapsulant. The component located within the central opening may be interconnected with the TSV by way of a redistribution layer formed on the semiconductor die. A bottom surface of the component may be substantially coplanar with a bottom surface of the die pad. The component may be characterized as at least one of a second semiconductor die and a passive integrated device (PID).

By now, it should be appreciated that there has been provided a semiconductor device having enhanced solderability. The semiconductor device includes a semiconductor die mounted on a die pad of a leadframe. A plurality of leads of the leadframe substantially surround the die pad. The die pad is formed with a central opening through the die pad. An outer perimeter portion of the back of the semiconductor die is affixed to an outer perimeter portion of the die pad such that a central portion of the semiconductor die is exposed through the opening. A redistribution layer substrate is formed on the semiconductor die portion exposed through the opening. The redistribution layer substrate is configured to interconnect through-silicon vias of the semiconductor die with a component affixed within the opening of the die pad. The component may be a second semiconductor die, a sensor, a passive component, an integrated passive, for example. The semiconductor die and portions of the leadframe and the component are encapsulated with an encapsulant. Each lead of the plurality of leads includes a lead portion exposed and protruded through the bottom side of the encapsulant. Likewise, the bottom side of the die pad and a bottom side of the component are exposed and protruded through the bottom side of the encapsulant. By forming the semiconductor device in this manner, the component may be included in the semiconductor device with little to no impact to the height or thickness of the semiconductor package. Further, by encapsulating the semiconductor device such that protruded leads and die pad are formed, the additional surface area of the protruded leads and die pad provide enhanced solderability when mounting the semiconductor device onto a printed circuit board, for example.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method of comprising:
mounting a semiconductor die on a die pad of a leadframe, the die pad having a central opening configured to expose a central portion of the semiconductor die;
attaching a first end of a bond wire to a bond pad of the semiconductor die and a second end of the bond wire to a lead of the leadframe; and
encapsulating with an encapsulant the semiconductor die and the leadframe, a portion of the lead and a portion of the die pad exposed and protruded through the encapsulant.

2. The method of claim 1, further comprising before encapsulating with the encapsulant, interconnecting a component located within the central opening with a through-silicon via, TSV, of the semiconductor die.

3. The method of claim 2, wherein the component located within the central opening is interconnected with the TSV by way of a redistribution layer formed on the semiconductor die.

4. The method of claim 2 or 3, wherein a bottom portion of the component protrudes through the encapsulant after encapsulating with the encapsulant.

5. The method of any one of claims 2 to 4, further comprising forming a metal layer on a bottom side of the component.

6. The method of any one of claims 2 to 5, wherein the component is characterized as at least one of a second semiconductor die and a passive integrated device, PID.

7. The method of any one of claim 2 to 6, wherein a bottom surface of the component is substantially coplanar with a bottom surface of the die pad.

8. The method of any preceding claim, wherein the central opening of die pad is configured to expose the central portion of a backside of the semiconductor die.

9. The method of any preceding claim, wherein the leadframe is characterized as a quad flat no-lead, QFN, package type leadframe.

10. A semiconductor device comprising:
a leadframe including a die pad and a plurality of leads, the die pad having a central opening through the die pad;
a semiconductor die mounted on the die pad of the leadframe, a portion of the semiconductor die exposed through the central opening; and
an encapsulant encapsulating with the semiconductor die and the leadframe, a portion of the die pad and plurality of leads exposed and protruded through the encapsulant.

11. The semiconductor device of claim 10, further comprising a bond wire having a first end connected to a bond pad of the semiconductor die and a second end of the bond wire connected to a lead of the plurality of leads.

12. The semiconductor device of claim 10 or 11, further comprising a component located substantially within the central opening, the component interconnected with a through-silicon via, TSV, of the semiconductor die.

13. The semiconductor device of claim 12, wherein the component located within the central opening is interconnected with the TSV by way of a redistribution layer formed on the semiconductor die.

14. The semiconductor device of claim 12 or 13, wherein a bottom portion of the component is exposed and protruded through the encapsulant, and wherein a bottom surface of the component is substantially coplanar with a bottom surface of the die pad.

15. The semiconductor device of any one of claims 12 to 14, wherein the component is characterized as at least one of a second semiconductor die and a passive integrated device, PID.
